# EUROPEAN PATENT APPLICATION

(11) **EP 4 557 379 A1**
(43) Date of publication of application: **21.05.2025**
(21) Application number: 23838840.9
(22) Date of filing: 06.07.2023
(51) Int. Cl.: H01L 31/0216, H01L 31/0304, H01L 31/105

(54) **ARTIFICIAL MICROSTRUCTURE INTEGRATED INAS-BASED INFRARED PHOTOELECTRIC DETECTOR**

(30) Priority: 11.07.2022 CN 202210811436
(71) Applicant: Shanghai Institute of Technical Physics of the Chinese Academy of Science, Shanghai 200083 (CN)
(72) Inventor: HAO, Jiaming, Shanghai 200083 (CN); HU, Shuhong, Shanghai 200083 (CN); ZHOU, Ziji, Shanghai 200083 (CN); LIN, Hongyu, Shanghai 200083 (CN); SUN, Yan, Shanghai 200083 (CN); DAI, Ning, Shanghai 200083 (CN)
(74) Representative: Lermer, Christoph
(86) International application number: PCT/CN2023/106111
(87) International publication number: WO 2024/012348

(57) **Abstract**

Disclosed is an artificial microstructure integrated InAs-based infrared photoelectric detector. The detector sequentially comprises, from bottom to top, an InAs substrate, an InAsSbP barrier layer, an InAs absorption layer and an InAsSbP window layer, and a lower electrode is prepared on the barrier layer, an upper electrode is prepared on the window layer, and an artificial microstructure is pre-pared in the upper electrode on the window layer. **The** key points of the present invention are that the provided photoelectric detector has a wide effective detection wavelength coverage range, a high response rate, a high operating temperature and a low dark current, and can operate at a zero bias voltage.

## Description

### Technical Field

The disclosure relates to the technical field of semiconductor photodetector, in particular to an artificial micro-structure integrated InAs-based infrared photodetector.

### Background Art

Photodetectors operating in short- and Mid-wave infrared spectral ranges are of great significance in both military and civilian applications, such as military reconnaissance, infrared imaging guidance, environmental monitoring, intelligent agriculture, and thermophotovoltaics. As the rapid development of science and technology, the application scenarios of infrared photoelectric detection technology are becoming more and more extensive, and higher requirements have been put forward for the comprehensive performance of detection devices.

Group III-V semiconductor compound InAs and its alloys have been the key components in the manufacture of infrared detectors due to their advantages such as bandgap matching, high carrier mobility, and being able to work at room temperature. However, these detectors usually require a thick absorption layer and are limited by shortcomings, for instance, low absorption coefficient, insufficient responsivity, and large dark current, which greatly hinder their practical applications.

Increasing the responsivity and reducing the dark current are the two solutions to improve the performance of detectors. In order to fully absorb infrared light, the absorption layer of traditional detectors generally needs to have a certain thickness. In principle, using a thin absorption layer can effectively reduce the dark current. However, a thin absorption layer will lead to low quantum efficiency and responsivity. Therefore, the selection of the thickness of the device's absorption layer needs to be balanced. In recent years, artificially engineering micro- and nano-structures have attracted widespread attention because of their powerful ability to regulate the electromagnetic fields. By introducing such artificially engineering structures, the incident light energy can be concentrated and localized in the absorption layer of the material, greatly increasing the absorption efficiency of the absorption layer. Thus, a thinner absorption layer can be used to obtain high quantum efficiency while keeping the dark current low, and the comprehensive performance of the photodetection device can be significantly improved.

This invention discloses an artificial microstructure-integrated InAs infrared photodetector, which has the advantages of coveraging wideband wavelength spectrum, high responsivity, high operating temperature, low dark current, and the ability to work at zero bias voltage.

### Contents of the Invention

### (1) Technical Problems to be Solved

To address the above problems, this invention discloses an artificial microstructure-integrated InAs infrared photodetector, which is utilized to solve or at least partially solve the problems such as low responsivity, large dark current and low signal-to-noise ratio of traditional InAs photodetectors.

### (2) Technical Scheme

The invention discloses an artificial microstructure-integrated InAs infrared photodetector. which basically consists of a substrate 1, a barrier layer 2, an absorption layer 3, a window layer 4. The lower electrode 5 and the upper electrode 6 are respectively fabricated on the barrier layer and the window layer, and the artificial microstructures 7 are fabricated on surface of the window layer.

The substrate 1 is a p-type InAs thin film layer with a (100) crystal orientation.

The barrier layer 2 is a p-type doped InAs_{1-x-y}SbₓP_{y} thin film layer.

The absorption layer 3 is an unintentionally doped InAs thin film layer with a carrier concentration of 3-5×10¹⁶ cm⁻³ and a thickness of 0.5-8µm.

The window layer 4 is an n-type doped InAs_{1-x-y}SbₓP_{y} thin film layer.

The lower electrode 5 and the upper electrode 6 are composite metal electrodes composed of Ti and Au with a thickness of 0.05-0.5 µm.

The artificial microstructure 7 is composed of periodic units with a period of 2.5-5 µm. The unit is composed of two square microbricks made of Au and/or Ag of different sizes. The small square microbrick has a side length of 1-2µm and the large squares with a side length of 1.4 - 2.8 µm, which are made of Au and Ag with a thickness of 0.3 - 0.8 µm.

### Advantages of the Invention:

Due to the presence of the artificial microstructure layer 7, this type of photodetector not only reduces the optical reflection on the surface of the device in the operating wavelength spectral band, but also utilizes the plasmonic resonant mode to concentrate the incident light energy, greatly enhancing the responsivity and suppressing the dark current of the device, and enabling it to have high responsivity and detectivity at the room temperature.

### Description of the Drawings

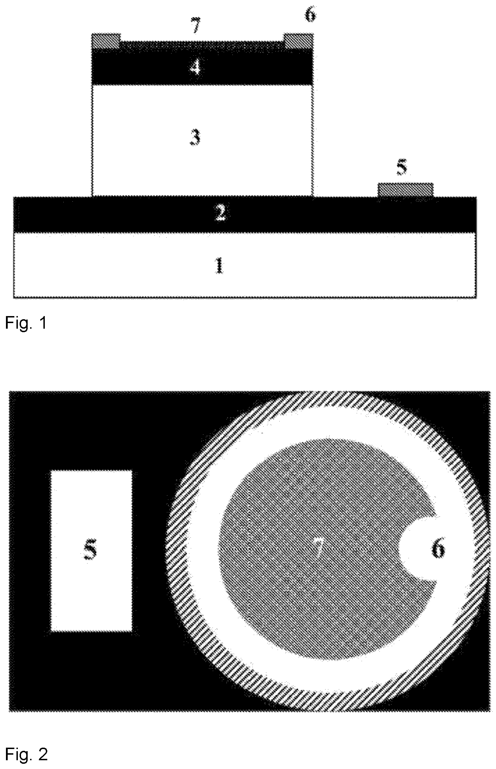

Figure 1 shows a structural cross-sectional view of the artificial microstructure-integrated InAs-based infrared photodetector in an embodiment of the invention.
Figure 2 shows a top view of the structure of the artificial microstructure-integrated InAs-based infrared photodetector in an embodiment of the invention.

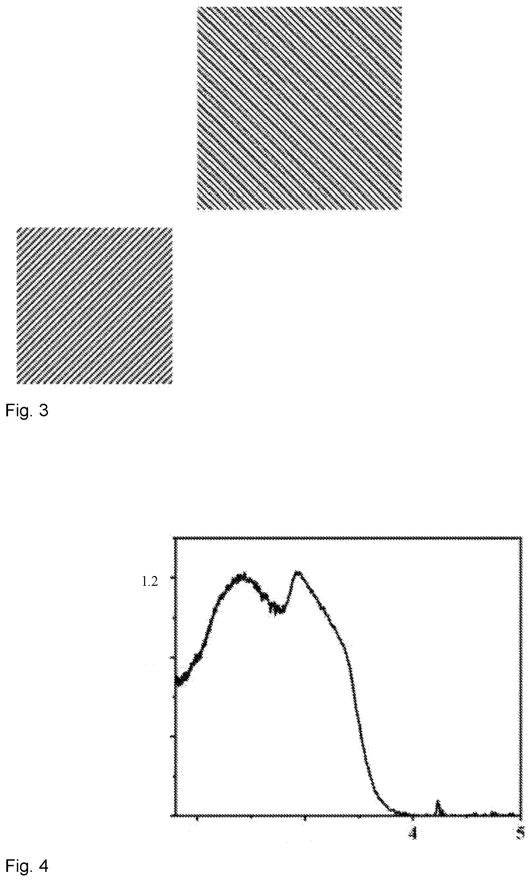

Figure 3 is a schematic diagram of the unit cell of microstructures of the artificial microstructure-integrated InAs infrared photodetector in an embodiment of the invention.
Figure 4 presents the room-temperature zero-bias detectivity of the artificial microstructure-integrated InAs infrared detector in an embodiment of the invention.

### Specific Mode for Carrying out the Invention

In order to make the objectives, technical solutions, and advantages of the present invention more clearly understood, the invention is further elaborated in detail in the following combination with specific embodiments and with reference to the accompanying drawings.

Embodiment 1: The material of the substrate 1 is p-type InAs with a (100) crystal orientation. The material of the barrier layer 2 is p-type doped InAs1-x-ySbxPy with a wide bandgap. The absorption layer 3 is unintentionally doped InAs with a carrier concentration of 3×10¹⁶ cm⁻³ and a thickness of 0.5µm. The window layer 4 is n-type doped InAs1-x-ySbxPy with a wide bandgap. The lower electrode 5 and the upper electrode 6 are Ti and Au metal electrodes with a thickness of 0.05 µm. The periodicity of artificial microstructures 7 is 2.5 µm. The small and large square microbricks have the side length of 1µm and 1.4µm, respectively, which are made of Au and Ag and have a thickness of 0.3µm.

Embodiment 2: The material of the substrate 1 is p-type InAs with a (100) crystal orientation. The material of the barrier layer 2 is p-type doped InAs1-x-ySbxPy with a wide bandgap. The absorption layer 3 is unintentionally doped InAs with a carrier concentration of 3×10¹⁶ cm⁻³ and a thickness of 0.5µm. The window layer 4 is n-type doped InAs1-x-ySbxPy with a wide bandgap. The lower electrode 5 and the upper electrode 6 are Ti and Au metal electrodes with a thickness of 0.05 µm. The periodicity of artificial microstructures 7 is 5 µm. The small and large square microbricks have the side length of 2µm and 2.8µm, respectively, which are made of Au and Ag and have a thickness of 0.8µm.

Embodiment 3: The material of the substrate 1 is p-type InAs with a (100) crystal orientation. The material of the barrier layer 2 is p-type doped InAs1-x-ySbxPy with a wide bandgap. The absorption layer 3 is unintentionally doped InAs with a carrier concentration of 3×10¹⁶ cm⁻³ and a thickness of 0.5 µm. The window layer 4 is n-type doped InAs1-x-ySbxPy with a wide bandgap. The lower electrode 5 and the upper electrode 6 are Ti and Au metal electrodes with a thickness of 0.05 µm. The periodicity of artificial microstructures 7 is 3.25 µm. The small and large square microbricks have the side length of 1.5µm and 1.9µm, respectively, which are made of Au and Ag and have a thickness of 0.55µm.

All three embodiments adopt the following processes:
1. Utilizing the liquid phase epitaxy method to sequentially grow the barrier layer 2, the absorption layer 3, and the window layer 4 in situ on the InAs substrate. Using the etching process to etch from top to bottom to form a mesa. The etching stops at the barrier layer 2, so that for the fabricated device, the exposed parts are the barrier layer 2 and the window layer 4.
2. The standard photolithography process is used to open electrode holes on the surface of the device, and then use the thermal evaporation (vacuum sputtering, electron beam evaporation and other methods are all applicable) method to form the lower electrode 5 and the upper electrode 6.
3. Using the alignment and overlay process to open artificial microstructure holes within the annular region of the upper electrode 6 on the sample, and then employing the electron beam evaporation method to grow Au and Ag to form the artificial microstructure layer 7.

The performance of the devices fabricated in the three embodiments is quite similar. Under the condition of room temperature and zero bias voltage, the responsivity has been significantly improved compared with that of devices without the microstructure.

The above specific embodiments further elaborate on the objectives, technical solutions, and beneficial effects of the present invention. It should be understood that the above are only specific embodiments of the invention and are not intended to limit the invention. Any modifications, equivalent replacements, improvements, etc. made within the spirit and principles of the present invention shall be included within the protection scope of the invention.

## Claims

1. An artificial microstructure-integrated InAs-based infrared photodetector, comprising a substrate (1), a barrier layer (2), an absorption layer (3), and a window layer (4), and is **characterized in that**:
The structure of the artificial microstructure-integrated InAs-based infrared photodetector basically composed of, from bottom to top, the substrate (1), the barrier layer (2), the absorption layer (3), and the window layer (4); the lower electrode (5) is fabricated on the barrier layer, the upper electrode (6) is fabricated on the window layer; and the artificial microstructures (7) are fabricated on the surface of window layer (4) within the upper electrode (6).

2. The artificial microstructure-integrated InAs-based infrared photodetector as claimed in claim 1, is **characterized in that** the substrate (1) is a p-type InAs thin film layer with a (100) crystal orientation.

3. The artificial microstructure-integrated InAs-based infrared photodetector as claimed in claim 1, is **characterized in that** the absorption layer (3) is an unintentionally doped InAs thin film layer with a carrier concentration of 3-5×10¹⁶ cm⁻³ and a thickness of 0.5-8 µm.

4. The artificial microstructure-integrated InAs-based infrared photodetector as claimed in claim 1, is **characterized in that** the lower electrode (5) and the upper electrode (6) are composite metal electrodes composed of Ti and Au with a thickness of 0.05 - 0.5 µm.

5. The artificial microstructure InAs-based infrared photodetector as claimed in claim 1, is **characterized in that** the artificial microstructure 7 is composed of periodic units with a period of 2.5-5 µm. The unit is composed of two square microbricks made of Au and/or Ag of different sizes. The small square microbrick has a side length of 1-2µm and the large squares with a side length of 1.4 - 2.8 µm, which are made of Au and Ag with a thickness of 0.3 - 0.8 µm.
